Europäisches Patentamt

European Patent Office

Office européen des brevets

(19)

(11) **EP 0 912 021 A2**

(12) **EUROPÄISCHE PATENTANMELDUNG**

(43) Veröffentlichungstag:
28.04.1999 Patentblatt 1999/17

(51) Int. Cl.⁶: $H04L\ 25/49$, $H03M\ 13/12$

(21) Anmeldenummer: 98113571.8

(22) Anmeldetag: 20.07.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 01.08.1997 DE 19733335

(71) Anmelder:
SIEMENS AKTIENGESELLSCHAFT
80333 München (DE)

(72) Erfinder:
• Emmer, Dieter
  82110 Germering (DE)
• Franz, Volker
  82178 Puchheim (DE)

(54) **Verfahren und Einrichtung zur Datenübertragung**

(57)     In dem Verfahren zur Datenübertragung, bei dem von einer Datenquelle Daten in Bits abgegeben werden, die in Blöcken zusammengefaßt sind, in einem Codierer die von der Datenquelle abgegebenen Blöcke codiert werden, die codierten Blöcke über einen Übertragungskanal gesendet werden, die gesendeten Blöcke empfangen und von einem Entzerrer entzerrt werden, die entzerrten Blöcke decodiert werden, und die decodierten Blöcke an eine Datensenke abgegeben werden, werden die codierten Blöcke über P Übertragungskanäle mit P >= 2 gleichzeitig gesendet, in wenigstens einem der Übertragungskanäle senderseitig wird ein Interleaving und empfängerseitig ein entsprechendes Deinterleaving durchgeführt, bei der Entzerrung wird eine Turbo-Entzerrung unter Einbeziehung der über alle Kanäle gesendeten Blöcke durchgeführt, und schließlich werden die entzerrten Blöcke einem Deinterleaving unterworfen. Das Verfahren eignet sich insbesondere für einen Einsatz in Funk-Kommunikationssystem, z.B. Mobilfunknetzen.

FIG 1

FIG 2

EP 0 912 021 A2

# Beschreibung

Die Erfindung bezieht sich auf ein Verfahren und eine Einrichtung zur Datenübertragung.

Bei einer herkömmlichen Übertragungsstrecke zur Übertragung und zum Empfang von Daten werden die Daten von einer Datenquelle in Form von Bits geliefert. Diese Bits werden in Blöcken zusammengefaßt und einem Faltungscodierer (convolutional coder) zugeführt, der Redundanz hinzufügt. Die codierten Datenblöcke werden in einem Interleaver verwürfelt. Die Datenblöcke werden nach dem Interleaving über einen ISI-Kanal (ISI = Intersymbolinterferenz) übertragen und in einem Entzerrer entzerrt. Nachdem der Entzerrer die Interferenzen beseitigt hat, gibt er entzerrte Datenblöcke an den Deinterleaver ab, und dieser gibt die Datenblöcke nach dem Deinterleaving an den Decodierer ab, der dann den Großteil der Fehler korrigiert und seine Ausgangssignale an die Datensenke weitergibt.

Der Erfindung liegt die Aufgabe zugrunde, ein Verfahren und eine Einrichtung zur Datenübertragung anzugeben, bei dem die in einem ISI-Übertragungskanal auftretenden Übertragungsfehler besser als bisher korrigiert werden können, die insbesondere bei der Datenbertragung und dergleichen auftreten. Die Aufgabe wird durch das Verfahren mit den Merkmalen des Patentanspruchs 1 und die Einrichtung mit den Merkmalen des Patentanspruchs 11 gelöst.

Zur Lösung dieser Aufgabe wird ein Verfahren zur Datenübertragung angegeben, bei dem

- von einer Datenquelle Daten in Bits abgegeben werden, die in Blöcken zusammengefaßt sind,
- in einem Codierer, die von der Datenquelle abgegebenen Blöcke codiert werden,
- die codierten Blöcke über einen Übertragungskanal gesendet werden,
- die gesendeten Blöcke empfangen und von einem Entzerrer entzerrt werden,
- die entzerrten Blöcke decodiert werden, und
- die decodierten Blöcke an eine Datensenke abgegeben werden, wobei
- die codierten Blöcke über P Übertragungskanäle mit P > = 2 gesendet werden,
- in mehreren Übertragungskanälen senderseitig ein Interleaving und empfängerseitig ein entsprechendes Deinterleaving durchgeführt wird,
- bei der Entzerrung eine Turbo-Entzerrung unter Einbeziehung der über mehrere Kanäle gesendeten Blöcke durchgeführt wird, und wobei
- die entzerrten Blöcke einem Deinterleaving unterworfen werden.

Die Turbo-Entzerrung beziehungsweise Turbo-Demodulation ist an sich bekannt, wurde aber bisher für die hier betrachteten Zwecke für nicht geeignet erachtet, wie sich aus folgendem ergibt.

In ICC '95, Seattle, Washington, Juni 18-22, 1995, „Turbo Codes for BCS Applications", D. Divsalar und F. Pollara, werden Turbocodes vorgeschlagen, um eine Fehlerkorrektur bis nahe an die sogenannte Shannon-Grenze zu erreichen. Dazu sollen verhältnismäßig einfache Komponentencodes und große Interleaver verwendet werden. In dieser Veröffentlichung werden die Turbocodes in einem Codierer mit mehrfachen Codes erzeugt und in einem geeigneten Decodierer decodiert. Die Turbocodes wurden von Berrou et al. 1993 eingeführt (siehe C. Berrou, A. Glavieux und P. Thitimayshima, „Near Shannon limit area correction coding: Turbo codes" Proc. 1993 IEE International conference on communications, Seiten 1064-1070). Mit dieser Methode kann einerseits eine sehr gute Fehlerkorrektur erreicht werden. Andererseits besteht ein wesentlicher Nachteil darin, daß Datenblöcke nur als Ganzes über große Interleaver einem Interleaving unterzogen werden können.

Aus J. G. Proakis: „Digital Communications", Mc Graw-Hill Series in Electrical Engeneering, 2. Auflage, 1989, Seiten 487-493 ist die codierte Modulation für bandbreitenbeschränkte Kanäle bekannt, wobei es im wesentlichen darum geht, daß durch die Codierung ein wirksames Verfahren entwickelt wird, um einen Kompromiß zwischen Bandbreite und Komplexität der Einrichtung einerseits und Senderleistung andererseits zu finden. Dies spielt insbesondere bei digitalen Übertragungssystemen eine Rolle, die dafür bestimmt sind, in einem Bereich begrenzter Sendeleistung zu arbeiten. Für bezüglich der Bandbreite eingeschränkte Kanäle wird das digitale Kommunikationssystem so ausgelegt, daß eine im Bezug auf die Bandbreite effiziente Multilevel/ Phasenmodulation, beispielsweise ASK, PSK, DPSK oder QAM gewählt werden. Wenn eine Codierung bei einem bezüglich der Bandbreite beschränkten Kanal angewendet wird, wird ein Performancegewinn angestrebt, ohne die Signalbandbreite auszudehnen. Dieses Ziel soll dadurch erreicht werden, daß die Zahl der Signale über das entsprechende uncodierte System erhöht wird, um die durch den Code eingeführte Redundanz zu kompensieren. In dieser Veröffentlichung wird insbesondere die Trellis-codierte Modulation bei 8-PSK beschrieben, und die Decodierung erfolgt über eine Soft-Decision-Viterbi-Decodierung.

Aus ETT European Transactions on Telecommunications, Vol. 6, No. 5, September-October 1995, „Iterative Correction of Intersymbol Interference: Turbo-Equalization", Catherine Douillard et al. ist die sogenannte Turbo-Entzerrung bekannt, mit der die nachteiligen Effekte der Intersymbolinterferenz bei digitalen Übertragungssystemen behoben werden sollen, die durch Faltungscodes geschützt sind. Der Empfänger führt zwei aufeinanderfolgende Soft-Output-Entscheidungen aus, die von einem Symboldetektor und einem Kanaldecodierer über einen iterativen Prozess durchgeführt werden. Bei jeder Iteration wird extrinsische Information aus dem Detektor und dem Decoder bei der nächsten Iteration wie bei der Turbodecodierung verwendet. Es wird gezeigt, daß mit der Turbo-Entzerrung Intersymbolinterferenz Effekte bei Mehrweg-Kanälen überwunden werden können. Auch hier werden nur blockweise dem Interleaving unterworfene Datenblöcke der Turbo-Entzerrung unterworfen.

Bei dem erfindungsgemäßen Verfahren werden in vorteilhafter Weise die oben erwähnten bekannten Techniken ausgenutzt, um die gestellte Aufgabe zu lösen. Dabei wird nicht nur die Turbo-Entzerrung als solche eingesetzt, sondern es werden bei der Turbo-Entzerrung Blöcke miteinander verarbeitet, die über unterschiedliche Übertragungskanäle übertragen worden sind, was bei der Turbo-Entzerrung einen zusätzlichen Effekt in Richtung auf eine Verbesserung der Fehlerbeseitigung bringt.

Nach einer vorteilhaften Ausgestaltung des erfindungsgemäßen Verfahrens wird die Turbo-Entzerrung in einer seriellen, Master-Slave- oder parallelen Anordnung durchgeführt, wie in der Veröffentlichung von D. Divsalar und F. Pollara (siehe oben) vorgeschlagen wurde. Mit anderen Worten kann bei dem erfindungsgemäßen Verfahren das volle Spektrum der bekannten Codierungsverfahren ausgenutzt werden.

Nach einer vorteilhaften Ausgestaltung des erfindungsgemäßen Verfahrens werden in den Interleavern n Datenblöcke miteinander verwürfelt, wobei in jedem einem Interleaving unterworfenen Datenblock Informationen von n Datenblöcken vorhanden sind, daß durch die Turbo-Entzerrung von Blöcken n Informationen über die Datenblöcke n, n - 1, n - 2, ..., n - N + 1 gewonnen werden, wobei diese Informationen einem Interleaving unterworfen und die so gewonnenen Informationen erneut entzerrt werden, um mit dieser neuen a-priori Information die Blöcke n - N + 1 bis n erneut zu entzerren und damit eine Information über die einem Interleaving unterworfenen Datenblöcke n - N + 1 bis n + N - 1 zu erzeugen.

Bei dem erfindungsgemäßen Verfahren werden daher, bevor der Decoder die a-priori Werte während der Iteration zu entzerrenden Datenbits in den Datenblöcken liefert, die schon vorhandenen Daten des Decoders zurückgeführt. Obwohl am Entzerrer nicht für jedes Codebit a-priori Informationen vorliegen, kann durch die erneute Entzerrung eine Verbesserung der Bitfehlerrate (BER) erzielt werden. Dabei ist vorteilhaft, daß auch zeitkritische Anwendungen wie Sprachübertragung und Videoübertragung und dergleichen iterativ detektiert werden können.

Es ist weiterhin vorteilhaft, daß das erfindungsgemäße Verfahren auch bei Systemen nach dem GSM-Standard anwendbar ist, wobei die Faltungscodierung und das Interleaving nach den verschiedenen GSM-Standards erfolgt. Auch kann bei der Codierung eine codierte Modulation, insbesondere eine Trelliscodierte PSK-Modulation durchgeführt werden, die in einem Demodulator empfängerseitig wieder rückgängig gemacht wird. Es ergibt sich so die vorteilhafte Möglichkeit auf diese Codierungs- beziehungsweise Modulationsart zusammen mit einem gängigen Interleaving-Verfahren bei der Erfindung einzusetzen.

Die oben gestellte Aufgabe wird ferner durch eine Einrichtung zur Datenübertragung gelöst, wie sie in Anspruch 11 angegeben ist.

Weitere vorteilhafte Ausgestaltungen der Erfindung ergeben sich aus den restlichen Unteransprüchen.

Ausführungsbeispiele der Erfindung werden nun anhand der beiliegenden Zeichnungen beschrieben. Es zeigen:

Fig 1     ein Blockdiagramm für eine Übertragungsstrecke nach einer ersten Ausführungsform der Erfindung;

Fig 2     ein Blockdiagramm einer einer Übertragungsstrecke nach einer zweiten Ausführungsform der Erfindung;

Fig 3     ein Blockdiagramm einer Computersimulation für eine Übertragungsstrecke nach der Erfindung;

Fig 4     ein Blockdiagramm einer Comutersimulation für eine weitere Ausführungsform der Erfindung;

Fig 5     eine graphische Darstellung einer Computersimulation.

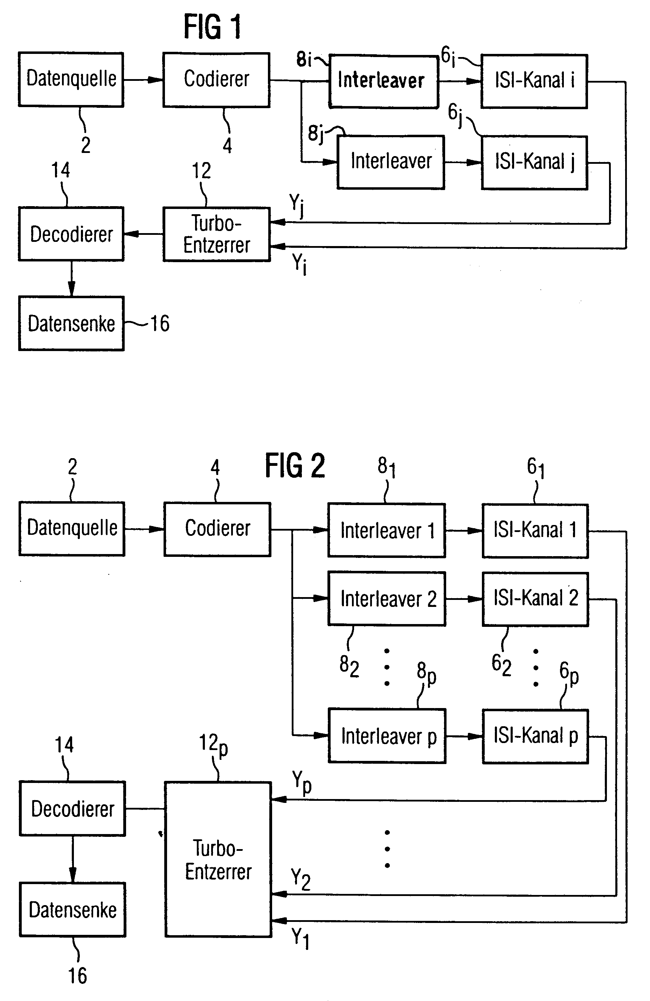

In Figur 1 ist eine Übertragungsstrecke eines digitalen Übertragungssystems dargestellt. Die Datenquelle 2 gibt Daten in Form von Bits oder anderen Symbolen ab, die in Blöcken zusammengefaßt sind. Bei einem GSM-System ist die Datenquelle 2 der Sprachcodierer. Die Datenblöcke von der Datenquelle 2 gelangen zu einem Codierer 4, beispielsweise einem Faltungscodierer, in dem, um die Informationsbits gegen Übertragungsfehler zu schützen, durch Kanalcodierung zusätzliche Redundanz hinzugefügt wird.

Die codierten Datenblöcke werden zum einen über einen Interleaver $8_i$ und einen ISI Kanal $6_i$ und zum anderen über einen Interleaver $8_j$ und einen ISI-Kanal $6_j$ an einen Turbo-Entzerrer 12 übertragen. Bei den ISI-Kanälen $6_i$ und $6_j$ muß man im nachteiligsten Fall von zeitvarianten, frequenzselektiven Fadingkanälen ausgehen. Die Kanäle wirken dabei für die übertragenen Datenblöcke wie eine Zufallscodierung (random coding), wobei die Codierung der beiden Kanäle des Codierers 4 überlagert werden.

In dem Turbo-Entzerrer 12 wird das Interleaving des Interleavers 8 rückgängig gemacht. Die entzerrten Datenblöcke am Ausgang des Turbo-Entzerrers 12 werden über einen Decodierer 14, in dem die Datenblöcke decodiert werden, wobei die Codierung des Codierers 4 rückgängig gemacht wird, an eine Datensenke 16 weitergegeben, die in einem GSM-System dem Sprachdecodierer entspricht.

Bei dieser Ausführungsform können die ISI-Kanäle gleich oder unterschiedlich sein. Während in Figur 1 nur zwei Übertragungskanäle dargestellt sind, ist die Zahl der Kanäle, die bei dem erfindungsgemäßen Verfahren in die Turbo-Entzerrung einbezogen werden, theoretisch unbegrenzt, wobei jedoch die Praxis gewisse Grenzen setzt.

Figur 2 zeigt ein Ausführungsbeispiel mit P (P > = 2) Übertragungskanälen $6_1$, $6_2$, ..., $6_P$ und einer entsprechenden Anzahl von Interleavern $8_1$, $8_2$, ..., $8_P$ Die übertragenen Datenblöcke werden einem Turbo-Entzerrer $12_P$ zugeführt, indem diese Blöcke $Y_P$ gemeinsam einer Turbo-Entzerrung unterworfen werden.

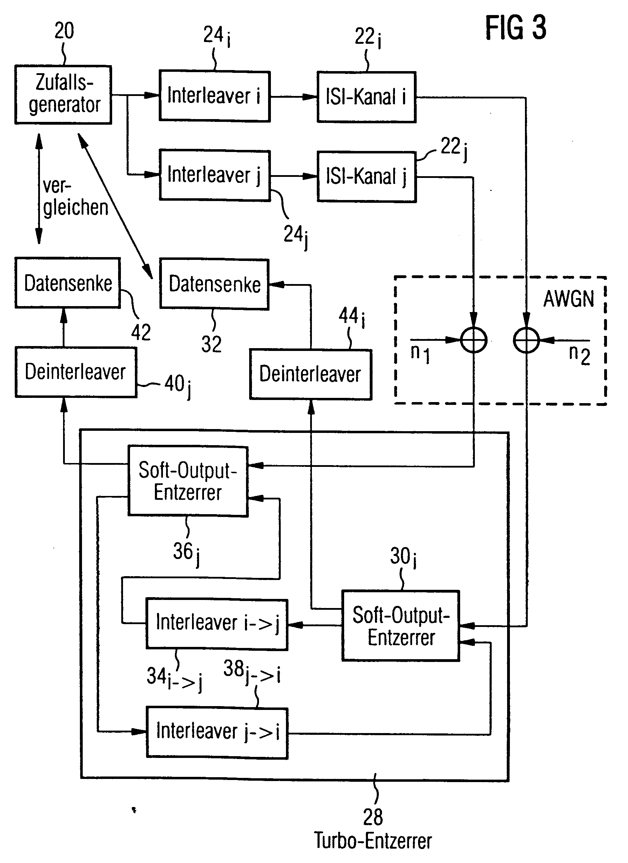

In Figur 3 ist das Blockdiagramm einer Computersimulation für das in Figur 1 gezeigte Ausführungsbeispiel dargestellt. Von einem Zufallsgenerator 20 werden Datenblöcke erzeugt und einerseits über einen Interleaver $24_i$ und einen ISI-Kanal $22_i$ und andererseits über einen Interleaver $24_j$ und einen ISI-Kanal $22_j$ an den Turbo-Entzerrer 28 übertragen. Der Turbo-Entzerrer 28 umfaßt einen Soft-Output-Entzerrer $30_i$, dem die über den ISI-Kanal $22_i$ gesendeten Blöcke $y_i$ zugeführt werden. Ein Ausgang des Soft-Output-Entzerrers $30_i$ gelangt zu einer Datensenke 32, wo die Daten im Rahmen der Computersimulation zu einem Vergleich mit den von dem Zufallsgenerator 20 abgegebenen Blöcken bereit stehen.

Der andere Ausgang des Soft-Output-Entzerrers $30_i$ gelangt zu einem Interleaver $34_{i->j}$, und von dort zu einem Soft-Output-Entzerrer $36_j$, der an seinem anderen Eingang die Blöcke empfängt, die über den ISI-Kanal $22_j$ an den Turbo-Entzerrer 28 abgegeben werden. Der eine Ausgang des Soft-Output-Entzerrers $36_j$ wird über einen Deinterleaver $38_{j->i}$ an den Soft-Output-Entzerrer $30_i$ zurückgeführt, wodurch die Turbo-Entzerrung ver-wirklicht wird. Zwischen dem Soft-Output-Entzerrer $30_i$ und der Datensenke 32 ist ein Deinterleaver $44_i$ angeordnet. Der andere Ausgang des Soft-Output-Entzerrers $36_j$ gelangt über einen Deinterleaver 40 zu einer zweiten Datensenke 42, in der die Blöcke wiederum zu einem Vergleich mit den von dem Zufallsgenerator 20 abgegebenen Blöcken bereitstehen.

Der Interleaver $34_{i \rightarrow j}$ führt ein Interleaving durch, welches einem Übergang von dem Interleaving wie es von dem Interleaver $24_i$ durchgeführt wird, zu dem interleaving darstellt, welches von dem Interleaver $24_j$ durchgeführt wird. Der Interleaver 38 $_{j \rightarrow i}$ führt ein Interleaving durch, welches dem Interleaving des Interleavers $34_{i \rightarrow j}$ entgegengesetzt ist.

Bei diesem Ausführungsbeispielen werden den über die ISI-Kanäle $22_i$ beziehungsweise $22_j$ übertragenen Signalen Rauschsignale $n_1$ beziehungsweise $n_2$ überlagert, die als additives, weißes Gauß'sches Rauschen (Noise) AWGN verwirklicht sind, wie in den Figuren 3 bis 5 angedeutet ist.

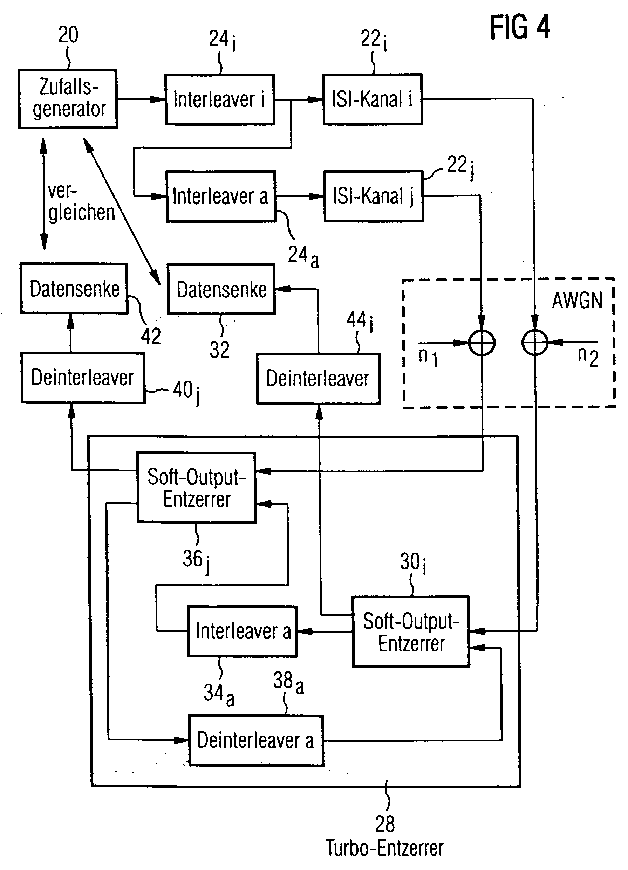

Figur 4 zeigt ein weiteres Ausführungsbeispiel einer Computersimulation, wobei der Interleaver $24_j$ von Figur 3 durch einen Interleaver $24_a$ ersetzt wurde, der dem Interleaver $24_i$ nachgeschaltet ist. Entsprechend ist zwischen dem Soft-Output-Entzerrer $30_i$ und dem Soft-Output-Entzerrer $36_j$ ein Interleaver $34_a$ vorgesehen, während zwischen dem Ausgang des Soft-Output-Entzerrers $36_j$ und dem Eingang des Soft-Output-Entzerrers $30_i$ ein Deinterleaver $38_a$ angeordnet ist. Der Interleaver $34_a$ und der Deinterleaver $38_a$ berücksichtigten die spezielle Interleaver Anordnung auf der Senderseite.

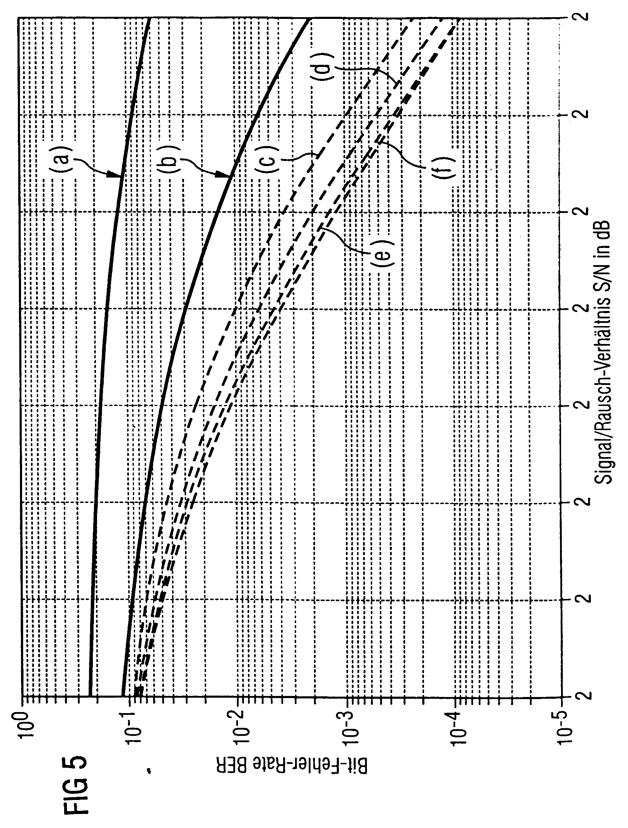

Figur 5 zeigt das Ergebnis der Computersimulation, wobei für die Kanäle i und j mit nachteiligsten Übertragungsbedingungen (Worstcase Channels) nach Proakis (siehe oben) angenommen wurden. In der Simulation weisen die ISI-Kanäle fünf Anzapfungen auf.

In der graphischen Darstellung ist die Bitfehlerrate BER gegen das Signal-/Rauschverhältnis S/N in dB dargestellt. Die Kurve (a) zeigt den Ausgang an dem Soft-Output-Entzerrer 30 bei der nullten (0.) Iteration bei der Turbo-Entzerrung. Die Kurve (b) zeigt den Ausgang des Soft-Output-Entzerrers 36, wobei zwar noch keine Iteration entsprechend der Turbo-Entzerrung stattgefunden hat, jedoch bereits eine Verarbeitung beider über die zwei Kanäle übertragenen Signale stattgefunden hat. Die Kurve (c) zeigt den Ausgang des Soft-Output-Entzerrers $30_i$ nach einer Iteration, während die Kurve (d) den Ausgang des Entzerrers $36_j$ nach der ersten (1.) Iteration darstellt. Die Kurven (e) und (f) zeigen die Ausgänge der Soft-Output-Entzerrer $30_i$ beziehungsweise $30_j$ nach der zweiten Iteration. Aus der graphischen Darstellung ist ersichtlich, daß der größte Gewinn im Bezug auf die Verbesserung der Bitfehlerrate BER bei der ersten Iteration stattfindet, so daß man davon ausgehen muß, daß mehr als drei Iterationen keine wesentliche Verbesserung der Bitfehlerrate BER mit sich bringen wird.

Im folgenden wird noch darauf eingegangen, wie das erfindungsgemäße Verfahren bezüglich der Turbodecodierung auf zeitkritische Systeme, wie das GSM System abgestimmt werden kann.

Bei dem GSM System können die codierten Daten eines SprachDatenblocks auf 8 Zeitschlitze aufgeteilt werden, wobei jeder Zeitschlitz Bits aus zwei aufeinanderfolgenden Datenblöcken enthält. Das bedeutet, daß für die iterative Entzerrung nur über jedes zweite Bit in einem Zeitschlitz a-priori Information aus der aktuellen Decodierung des Datenblocks n gewonnen werden kann. Die ersten vier Zeitschlitze, die Bits des Datenblocks n enthalten, enthalten außerdem Bits des Datenblocks n - 1, der bereits decodiert wurde. Die letzten vier Zeitschlitze mit Bits des Datenblocks n enthalten auch Bits des Datenblocks n + 1. Für diese Bits des Datenblocks n + 1 kann zum Zeitpunkt der Decodierung des Datenblocks n keine a-priori Information gewonnen werden, da zur Decodierung des Datenblocks n + 1 zunächst der Empfang von vier weiteren Zeitschlitzen mit den restlichen Bits des Datenblocks n + 1 abgewartet werden müßte.

Zur iterativen Entzerrung für den Datenblock n werden daher jeweils acht Zeitschlitze, die Bits des Datenblocks n enthalten, in jeder Iteration neu entzerrt. Für die Bits des Datenblocks n + 1 kann keine a-priori Information gewonnen werden. Für die Bits des Datenblocks n - 1 wird jeweils die a-priori Information aus der entsprechenden Iteration bei der iterativen Entzerrung des Datenblocks n - 1 verwendet. Eine Alternative dazu besteht darin, daß die iterative Entzerrung wie im letztgenannten Fall durchgeführt wird, wobei jedoch für die Bits des Datenblocks n - 1 jeweils die a-priori Information aus der letzten Iteration der iterativen Entzerrung des Datenblocks n - 1 verwendet wird. Eine weitere Alternative besteht darin, daß bei der iterativen Entzerrung des Datenblocks n auch der Datenblock n - 1 nochmals decodiert wird, um aktuelle a-priori Information über die Bits des Datenblocks n - 1 zu erhalten.

Es gibt keine Möglichkeit, in dem iterativen Verfahren über Klasse 2 Bits a-priori Information zu erhalten. Dennoch wird durch die iterative Entzerrung auch das Decodierergebnis der Klasse 2 Bits verbessert. Aufgrund der Codierung und Verwürfelung sind die Klasse 2 Bits gut über die Zeitschlitze verteilt und in der Regel von Klasse 1 Bits umgeben. Wenn für die Klasse 1 Bits eine gute a-priori Information zur Verfügung steht, so ergibt sich wegen des Kanalgedächtnisses auch eine bessere Decodierung für die eingeschlossenen Klasse 2 Bits.

Im folgenden wird eine allgemeine Erläuterung der Vorgehens-weise bei der Iteration gegeben, wie sie bei dem erfindungsgemäßen Verfahren durchgeführt wird. In den Interleavern werden N Datenblöcke miteinander verwürfelt, wobei in jedem einem Interleaving unterworfenen Datenblock Informationen von N Datenblöcken vorhanden sind. In diesem Fall werden durch die Entzerrung von Datenblöcken n in dem Entzerrer Informationen über die Datenblöcke n, n - 1, n - 2, ...., n - N + 1 gewonnen werden, und die so gewonnene Information wird wieder an den Entzerrer 10 zurückgeführt, um mit dieser neuen a-priori Information die Blöcke n - N + 1 bis n erneut zu entzerren und damit eine Information über die einem Interleaving unterworfenen Datenblöcke n - N + 1 bis n + N - 1 zu erzeugen.

O. Iteration

Durch die Entzerrung von Block n am Empfänger wird Information über die Datenblöcke n, n - 1, n - 2, ..., n - N + 1 gewonnen und somit können die Datenblöcke n - N + 1, ...., n - 2, n - 1, n entzerrt werden. Wenn zu diesem Zeitpunkt nur die Blöcke 1 bis n entzerrt worden sind, liegt für die Datenblöcke n - N + 2, ... n - 1, n noch nicht die vollständige Information vor. Diese Blöcke können dennoch entzerrt werden, indem man die noch nicht vorhandene Information als punktiert betrachtet.

Iteration:

Zunächst wird eine Variante beschrieben, bei der die beim Entzerrer erzeugte neue Information für Datenblöcke n - N + 1 bis n bzw. für die Blöcke n - N + 1 bis n verwendet wird. Für die Datenblöcke n - N + 1 bis n wurde durch die Entzerrung des Blockes n neue a-priori Information erzeugt. Dadurch wird Information über die dem Interleaving unterzogenen Blöcke n - N + 1 bis n + N - 1 generiert.

Es soll folgende erste Einschränkung gelten: Zunächst erfolgt eine Beschränkung der Verwendung der Information auf die Blöcke k < = n .

Die Datenblöcke n - N + 1 bis n können mit der neuen a-priori Information erneut entzerrt werden. Dadurch wird über den gesamten Datenblock n - N + 1 neue a-priori Information erzeugt. Die Anzahl M (1) der Blöcke, die erneut entzerrt werden, ist wie folgt wählbar: M (1) < = N . Durch die Entzerrung der Blöcke k = n - M (1) + 1 bis n erhält man neue a-priori Information zu den Datenblöcken k - N + 1 bis n, das heißt zu den Datenblöcken n - M (1) - N + 2 bis n.

Als zweite Einschränkung soll gelten: Zunächst werden die Datenblöcke n - N + 1 bis n erneut entzerrt.

Damit wird wieder eine neue Information zur Entzerrung der Datenblöcke n - N + 1 bis n + N - 1 erhalten. Die erste Iteration ist beendet.

Bei wiederholten Iterationen gelten die ersten und zweiten Einschränkungen weiter.

Nach einer zweiten Variante wird die vom Entzerrer 10 generierte Information für die Entzerrung der Daten k - N + 1 bis n für k = n - M + 1 bis n verwendet.

Die oben erwähnte zweite Einschränkung der ersten Variante wird aufgehoben, damit ergibt sich ab der zweiten Iteration eine Änderung zur der oben beschriebenen ersten Variante.

Durch die Entzerrung der Blöcke k = n - M (1) + 1 bis n in der ersten Iteration erhält man neue a-priori Information zu den Datenblöcken k - N + 1 bis n, das heißt für die Datenblöcke n - M (1) - N + 2 bis n.

Die oben erwähnte, erste Einschränkung gilt weiter. Durch die Entzerrung der Datenblöcke n - M (1) - N + 2 bis n wird a-priori Information zu den einem Interleaving unterworfenen Datenblöcken n + M (1) - N + 2 bis n + N - 1 erzeugt. Somit können in der folgenden Iteration die Blöcke n - M (1) - N + 2 bis n erzeugt entzerrt werden. Es können jetzt M (2) Blöcke entzerrt werden mit M (2) < = M (1) + N - 1 . Dadurch wird neue a-priori Information zu den Datenblöcken n - M (2) - N + 2 bis n erhalten. Durch weitere Iterationen können immer mehr schon vorher empfangene und entzerrte Datenblöcke erneut entzerrt werden. Somit wird die Information, die durch die Entzerrung erzeugt worden ist, bei vorher gesendeten Blöcken verwendet. Für die Iteration i (i>2) gilt: M (i) => M (i - 1) + N - 1 .

Bei einer dritten Variante, bei der beiden der oben erwähnten Einschränkungen aufgehoben sind, kann eine a-priori Information für die Entzerrung von noch nicht empfangenen Blöcken generiert werden.

**Patentansprüche**

1. Verfahren zur Datenübertragung bei dem

   a) von einer Datenquelle Daten in Bits abgegeben werden, die in Blöcken zusammengefaßt sind,
   b) in einem Codierer die von der Datenquelle abgegebenen Blöcke codiert werden,
   c) die codierten Blöcke über einen Übertragungskanal gesendet werden,
   d) die gesendeten Blöcke empfangen und von einem Entzerrer entzerrt werden,
   e) die entzerrten Blöcke decodiert werden, und
   f) die decodierten Blöcke an eine Datensenke abgegeben werden, dadurch gekennzeichnet, daß
   g) die codierten Blöcke über P Übertragungskanäle mit P > = 2 gesendet werden,
   h) in mehreren Übertragungskanälen senderseitig ein Interleaving und empfängerseitig ein entsprechendes Deinterleaving durchgeführt wird,
   i) bei der Entzerrung eine Turbo-Entzerrung unter Einbeziehung der über die Mehrzahl von Kanälen gesendeten Blöcke durchgeführt wird, und wobei
   k) die entzerrten Blöcke einem Deinterleaving unterworfen werden.

2. Verfahren nach Anspruch 1, dadurch gekennzeichnet, daß in allen Übertragungskänalen sendeseitig ein Interleaving beziehungsweise empfangsseitig eine Entzerrung und ein Deinterleaving durchgeführt wird.

3. Verfahren nach Anspruch 1, dadurch gekennzeichnet, daß die Turbo-Entzerrung in einer seriellen, master-slave- oder parallelen Anordnung durchgeführt wird.

4. Verfahren nach Anspruch 1 oder 3, dadurch gekennzeichnet, daß die Turbo-Entzerrung in einer vorgegebenen Anzahl von Iterationen durchgeführt wird.

5. Verfahren nach Anspruch 1 für den Fall P = 2, wobei in dem einen Übertragungskanal i ohne Interleaving und in dem anderen Übertragungskanal j mit Interleaving verfahren wird, dadurch gekennzeichnet, daß zur Turbo-Entzerrung die über den Übertragungskanal i übertragenen Blöcke einem Soft-Output-Entzerrer i und die über den Übertragungskanal j übertragenen Blöcke einem Soft-Output-Entzerrer j zugeführt werden, daß die entzerrten Blökke am Ausgang des Soft-Output-Entzerrers i über einen Interleaver j dem Soft-Output-Entzerrer j und die entzerrten Blöcke von dem Soft-Output-Entzerrer j über einen Deinterleaver j an den Soft-Output-Entzerrer i zurückgeführt werden.

6. Verfahren nach Anspruch 1 mit P = 2, wobei in den Übertragungskanal i ein Interleaver i und in dem Übertragungskanal j ein Interleaver j vorgesehen ist, dadurch gekennzeichnet, daß zur Turbo-Entzerrung die über den Übertragungskanal i übertragenen Blöcke einem Soft-Output-Entzerrer i und die über den Übertragungskanal j übertragenen Blöcke einem Soft-Output-Entzerrer j zugeführt werden, und das die entzerrten Blöcke am Ausgang des Soft-Output-Entzerrers i über einen Interleaver i→j dem Soft-Output-Entzerrer j und die entzerrten Blöcke von dem Soft-Output-Entzerrer j über einen Interleaver j→i an den Soft-Output-Entzerrer i zurückgeführt werden.

7. Verfahren nach Anspruch 1 mit P = 2, wobei in dem Übertragungskanal i ein Interleaver i und in dem Übertragungskanal j ein dem Interleaver i nachgeschalteter Interleaver a vorgesehen sind, dadurch gekennzeichnet, daß zur Turbo-Entzerrung die über den Übertragungskanal i übertragenen Blöcke einem Soft-Output-Entzerrer i und die über den Übertragungskanal j übertragenen Blöcke einem SoftOutput-Entzerrer j zugeführt werden, daß die entzerrten Blöcke am Ausgang des Soft-Output-Entzerrers i über einen Interleaver a dem Soft-Output-Entzerrer j und die entzerrten Blöcke von dem Soft-Output-Entzerrer j über einen Deinterleaver a an den Soft-Output-Entzerrer i zurückgeführt werden.

8. Verfahren nach Anspruch 1, dadurch gekennzeichnet, daß in den Interleavern N Datenblöcke miteinander verwürfelt werden, wobei in jedem einem Interleaving unterworfenen Datenblock Informationen von N Datenblöcken vorhanden sind, daß durch die Turbo-Entzerrung von Blöcken n Informationen über die Datenblöcke n, n - 1, n - 2, ...., n - N + 1 gewonnen werden, daß diese Informationen einem Interleaving unterworfen und die so gewonnenen Informationen erneut entzerrt werden, um mit dieser neuen a-priori Information die Blöcke n - N + 1 bis n erneut zu entzerren und damit eine Information über die einem Interleaving unterworfenen Datenblöcke n - N + 1 bis n + N - 1 zu erzeugen.

9. Verfahren nach Anspruch 8, dadurch gekennzeichnet, daß nur die Informationen über die Blöcke k < = n einem Interleaving unterworfen und zur erneuten Entzerrung zurückgeführt werden, um die Blöcke n - M (1)+ 1 bis n mit der neuen a-priori Information zu entzerren, wobei über den gesamten Datenblock n - M (1) + 1 neue a-priori Information erzeugt wird, daß die Anzahl M (1) der Blöcke, die erneut entzerrt werden, gewählt wird als M (1) < = N , wobei durch die Entzerrung der Blöcke k - n - M (1) + 1 bis n neue Information zu den Datenblöcken k - N + 1 bis n, das heißt zu den Datenblöcken n - M (1) - N + 2 bis n, gewonnen werden, daß nur die Datenblöcke n - N + 1 erneut entzerrt werden, wobei eine neue Information zur Entzerrung der Blöcke n - N + 1 bis n + N - 1 erhalten wird.

10. Verfahren nach Anspruch 9, dadurch gekennzeichnet, daß nur die Information über die Blöcke k < n einem Interleaving unterworfen und zur erneuten Entzerrung zurückgeführt werden, um die Blöcke n - M (1) + 1 bis n mit der neuen a-priori Information zu entzerren, wobei über den gesamten Datenblock n - M (1) + 1 neue a-priori Information erzeugt wird, daß die Anzahl M (1) der Blöcke, die erneut entzerrt werden, gewählt wird als M (1) < = N , wobei durch die Entzerrung der Blöcke k = n - M (1) + 1 bis n neue Information zu den Blöcken k - N + 1 bis n, das heißt zu den Datenblöcken n - M (1) - N + 2 bis n, gewonnen werden, daß nur die Datenblöcke n - N + 1 erneut entzerrt werden, wobei eine neue Information zur Entzerrung der Blöcke n - N + 1 bis n + N - 1 erhalten wird, daß die Datenblöcke n - M (1) - N + 2 erneut entzerrt werden, und daß M (2) Blöcke mit M (2) < = M (1) + N - 1 entzerrt werden, wobei neue a-priori Information zu den Datenblöcken n - M (2) - N + 2 bis n erhalten werden, wobei für die Iteration i (i = > 2) gilt: M (i) = > M (i - 1) + N - 1 .

11. Einrichtung zur Datenübertragung zur Durchführung des Verfahrens nach einem der vorhergehenden Ansprüche, mit einer Datenquelle, einem Codierer, einem ISI-Kanal, einem Entzerrer, einem Decodierer und einer Datensenke, dadurch gekennzeichnet, daß empfängerseitig ein Turbo-Entzerrer vorgesehen ist, in dem über P Übertragungskanäle (P>=2) übertragene Blöcke gemeinsam einer Turbo-Entzerrung unterworfen werden, bei der die Informationen aus der Entzerrung der empfangenen Blöcke als a-priori Information für diesen Block und/oder wenigstens einen zeitlich vorhergehenden Datenblock und/oder wenigstens einen zeitlich nachfolgenden Datenblock verwendet wird.

## FIG 1

## FIG 2

# FIG 3

Turbo-Entzerrer

FIG 4

Turbo-Entzerrer

FIG 5

Bit-Fehler-Rate BER

$10^0$

$10^{-1}$

$10^{-2}$

$10^{-3}$

$10^{-4}$

$10^{-5}$

(a)

(b)

(c)

(d)

(e)

(f)

2    2    2    2    2    2    2    2

Signal/Rausch-Verhältnis S/N in dB

EP 0 912 021 A2